(19) Europäisches Patentamt
European Patent Office
Office européen des brevets

(11) **EP 2 326 450 B1**

(12) **FASCICULE DE BREVET EUROPEEN**

(45) Date de publication et mention
de la délivrance du brevet:
**25.12.2013 Bulletin 2013/52**

(51) Int Cl.:
**B23H 3/04** *(2006.01)* **B23H 9/00** *(2006.01)*
**B81C 1/00** *(2006.01)*

(21) Numéro de dépôt: **09782811.5**

(22) Date de dépôt: **09.09.2009**

(86) Numéro de dépôt international:
**PCT/EP2009/061683**

(87) Numéro de publication internationale:
**WO 2010/031716 (25.03.2010 Gazette 2010/12)**

(54) **MACHINE ET PROCÉDÉ D'USINAGE D'UNE PIÈCE PAR MICRO-ÉLECTROÉROSION**

VORRICHTUNG UND VERFAHREN ZUM MIKRO-FUNKENERODIEREN EINES WERKSTUCKS.

MACHINE AND METHOD FOR MACHINING A PART BY MICRO-ELECTRICAL DISCHARGE MACHINING

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **19.09.2008 FR 0805148**

(43) Date de publication de la demande:
**01.06.2011 Bulletin 2011/22**

(73) Titulaires:
• **Université Lyon 1 Claude Bernard
69100 Villeurbanne (FR)**
• **Centre National de la Recherche Scientifique
75016 Paris (FR)**
• **Ecole Centrale de Lyon
69134 Ecully (FR)**

(72) Inventeur: **CABRERA, Michel
F-69007 Lyon (FR)**

(74) Mandataire: **Colombo, Michel et al
Brevinnov
310 avenue Berthelot
69008 Lyon (FR)**

(56) Documents cités:
**WO-A-2006/110489       JP-A- 58 015 630
JP-A- 2002 254 246       US-A- 5 145 564
US-A1- 2004 168 288**

EP 2 326 450 B1

## Description

L'invention concerne une machine et un procédé d'usinage d'une pièce par micro-électroérosion tel que décrit dans le préambule des revendications 1 et 7. Une telle machine et un tel procédé sont connus du document US2004168288, qui décrit l'état de la technique le plus proche.

De manière générale, l'électroérosion est également connue sous l'acronyme anglais EDM (Electrical Discharge Machining). Sa miniaturisation (connue sous le nom de micro EDM ou μEDM) comporte différentes variantes en fonction de la forme de l'électrode de gravure (qui sera également appelée ci-dessous « microélectrode »). Ces variantes sont les suivantes :

- La microélectroérosion par enfonçage dans laquelle une microélectrode de forme complémentaire à la forme à usiner est enfoncée dans la pièce.
- La microélectroérosion par fil avec un fil conducteur circulant ou animé d'un mouvement alternatif.
- Le perçage de trous par microélectroérosion, avec une électrode pointe ou une électrode tubulaire.
- Le fraisage par microélectroérosion, plus connu sous le terme anglais de « Milling EDM ».

Le fraisage par microélectroérosion n'implique pas nécessairement un mouvement de rotation de la microélectrode ou de la pièce usinée.

Dans la suite de cette description, lorsqu'on parle d'usinage par microélectroérosion, il s'agit de la technologie correspondant au fraisage par microélectroérosion.

Le déposant connaît des machines d'usinage d'une pièce par microélectroérosion présentant une configuration d'usinage dans laquelle une pointe d'une électrode de gravure est plongée dans un bain de fluide diélectrique (isolant) baignant une face à usiner de la pièce pour réaliser un usinage de cette pièce par électroérosion. Cette pointe étant suffisamment petite pour permettre la gravure de sillons dans la face dont la largeur transversale est supérieure à 10 μm.

Pour usiner des formes complexes, l'électrode décrit une trajectoire tridimensionnelle en enlevant progressivement la matière de la pièce, comme le ferait une micro-fraise dans le cadre d'un procédé par enlèvement de copeaux. La différence est que l'action élémentaire d'enlèvement de matière n'est pas une action mécanique mais une action thermique produite par un arc électrique. L'action de coupe est rapide. Le refroidissement est assuré par le bain de fluide diélectrique remplissant l'espace traversé par l'arc électrique entre l'électrode de gravure et la pièce à usiner. Cet espace est ici appelé « entrefer ». L'entrefer est connu sous le terme de « gap » en anglais.

L'électroérosion permet d'usiner tous les matériaux conducteurs (acier, titane, etc.) et semiconducteurs (silicium, carbure de silicium, etc.). Elle permet notamment d'usiner des métaux durs qui ne peuvent pas être usinés par des méthodes classiques. En effet il n'y a pas de contact mécanique entre l'électrode et la pièce à usiner.

L'électroérosion se distingue des procédés d'attaques électrochimiques connus sous l'acronyme anglais ECM (Electrochimical Machining) par la nécessité de créer une différence de potentiel importante entre l'électrode de gravure et la pièce à usiner. Pour créer cette différence de potentiel, le fluide diélectrique doit remplir l'entrefer. À l'inverse, l'usinage par attaque électrochimique est basé sur une réaction d'oxydation provoquée par un courant qui circule entre l'électrode de gravure et la pièce à usiner. Pour que ce courant puisse s'établir, l'électrode de gravure et la pièce à usiner sont plongées dans un bain d'électrolyte, c'est-à-dire un bain d'un fluide conducteur. L'attaque électrochimique peut être produite par un courant qui circule entre l'électrode de gravure et la pièce à usiner ou par des décharges de courant entre ces deux éléments. Lors de l'usinage d'une pièce par attaque électrochimique, l'usure de l'électrode est souvent négligeable. Cela n'est pas le cas dans le procédé d'électroérosion, où l'usure de l'électrode peut ne pas être négligeable.

Dans le cas du fraisage par microélectroérosion, l'électrode parcourt une trajectoire d'usinage pour usiner la face d'une pièce. Le grand intérêt de cette méthode est que la trajectoire d'usinage peut présenter plusieurs variations de hauteur par rapport à la face de la pièce à usiner ou même varier continûment. Lorsque cette trajectoire d'usinage présente plusieurs variations de hauteur par rapport à la face de la pièce à usiner, on dit ici que l'usinage est tridimensionnel. Un usinage tridimensionnel se traduit par la réalisation d'empreintes, de trous ou de rainures non-traversants dont les profondeurs par rapport à la face de la pièce varient par paliers. Il peut être obtenu directement à partir d'une définition numérique obtenue par Conception Assistée par Ordinateur, évitant ainsi la fabrication d'outillages complexes et coûteux (ce qui est le cas par exemple de la microélectroérosion par enfonçage). De manière générale, des facteurs de forme (rapport de la profondeur de perçage par le diamètre de perçage) importants peuvent être obtenus par ce procédé, soit typiquement des facteurs de forme supérieurs à 10 ou à 100.

Comme nous allons le voir ci-dessous, la fabrication des microélectrodes limite le développement de ce procédé alors que ces applications potentielles sont très importantes. En effet, par principe, le fraisage par micro-électroérosion permet d'envisager par exemple :

- l'usinage d'outillages :

  - moules en acier dur pour la microplasturgie
  - maîtres modèles pour le microtamponnage
  - empreintes métalliques par embossage à chaud plus connu sous les termes anglais de « hot embossing » ou de « micro hot embossing ».

- l'usinage de micropièces :

    - microturbines en matériaux très durs,
    - micro-échangeurs thermiques,
    - pièces médicales en titane (par exemple « microstent »)
    - buse d'injection diesel, etc.

Spécifiquement dans le domaine des micro-nanotechnologies, le fraisage par microélectroérosion permettrait d'usiner à très haute résolution des matériaux peu utilisés dans ce domaine (titane, SiC, diamant, etc.), et ce à bas coût. Par ailleurs il est très difficile par des techniques classiques de microtechnologie (FIB, RIE, etc) d'usiner des matériaux semiconducteurs avec un haut facteur de forme ; la principale technique utilisée dans ce cas étant le LIGA (Lithografie Galvanoformung Abformung), qui est très onéreuse. Il est même impossible à ces techniques de procéder à un usinage avec une variation continue en profondeur (le nombre de masques photolithographiques est toujours limité en microtechnologie). Ainsi même l'usinage du silicium pourrait tirer profit du fraisage par microélectroérosion à condition de pouvoir mettre en oeuvre facilement des électrodes avec des pointes suffisamment fines, c'est-à-dire de diamètre inférieur à 10 $\mu$m.

Or dans l'état de l'art actuel, les électrodes pour le fraisage par microélectroérosion sont des fils, des pointes ou des tubes de diamètre supérieur à 20-40 $\mu$m. En effet ces microélectrodes sont affinées par usinage mécanique (polissage par exemple), par électroérosion inverse ou encore par microélectroérosion à fil avec une électrode à fil circulant. Spécifiquement dans le cas du perçage de trous par microélectroérosion, des démonstrations de principe ont été réalisées avec des électrodes de 5 $\mu$m, mais ce principe n'a pas été étendu à l'usinage de formes complexes. Enfin dans le cas de la microélectroérosion à fil, le diamètre du fil est limité dans la pratique à 20 $\mu$m à cause de problèmes de tenue mécanique.

Pour réaliser de la micro-électroérosion, les électrodes de gravure sont très petites. Ces électrodes s'usent lors de l'usinage par micro-électroérosion. Par conséquent, il est nécessaire de les remplacer fréquemment. Ce remplacement d'électrodes est une tâche compliquée à cause de la petitesse et de la fragilité de ces électrodes. Par exemple, ce remplacement d'électrodes est réalisé manuellement après chaque usinage. Ces remplacements difficiles des électrodes limitent donc la productivité des machines actuelles d'usinage par micro-électroérosion.

De manière générale, la présente invention vise à pallier les défauts de l'état de l'art en proposant une machine d'usinage ayant une résolution inférieure à 10 $\mu$m et une productivité accrue.

Elle a donc pour objet une machine d'usinage par micro-électroérosion dans laquelle la machine comporte un mécanisme qui permet de modifier la configuration de la machine pour passer en alternance et de façon réversible de la configuration d'usinage à une configuration d'affûtage dans laquelle la pointe de la même électrode de gravure et une autre électrode sont plongées dans un bain d'électrolyte pour réaliser un affûtage par attaque électrochimique de la pointe de l'électrode de gravure.

Dans la machine ci-dessus, l'électrode est remplacée moins souvent car elle peut être réaffûtée sans qu'il soit nécessaire de la démonter de la machine d'usinage par micro-électroérosion. Cela limite donc les interventions de remplacement de l'électrode de gravure, ce qui accroît la productivité de cette machine.

De plus, l'affûtage par attaque électrochimique permet d'obtenir des pointes de diamètres compris entre 10 nm à 10 $\mu$m, typiquement entre 100 nm à 1 $\mu$m. Ainsi, des usinages avec une résolution inférieure à 10 $\mu$m sont possibles.

Les modes de réalisation de cette machine peuvent comporter une ou plusieurs des caractéristiques suivantes :

- la machine comporte un premier bac contenant le bain de fluide diélectrique et un second bac contenant le bain d'électrolyte et le mécanisme est apte à transporter l'électrode de gravure entre les premier et second bacs pour passer de la configuration d'usinage à la configuration d'affûtage et vice versa ;
- la machine comprend un premier bac contenant le bain de fluide diélectrique et un second bac contenant le bain d'électrolyte, et le mécanisme est apte à déplacer les premier et second bacs par rapport à l'électrode de gravure pour passer de la configuration d'usinage vers la configuration d'affûtage et vice versa ;
- la machine comprend un même bac contenant à la fois les bains de fluide diélectrique et d'électrolyte, ces bains ayant des densités volumiques différentes et étant non miscibles de sorte que ces bains sont superposés l'un au-dessus de l'autre ;
- la machine comprend un actionneur apte, dans la configuration d'usinage, à déplacer l'électrode de gravure perpendiculairement à la face à usiner de la pièce pour ajuster la largeur d'un entrefer entre la pointe de cette électrode et cette face à usiner et le même actionneur est apte, dans la configuration d'affûtage, à déplacer l'électrode de gravure perpendiculairement à la surface du bain d'électrolyte ;
- la machine comprend :

    - un actionneur commandable apte, dans la configuration d'usinage, à déplacer l'électrode de gravure perpendiculairement à la face à usiner de la pièce pour ajuster la largeur d'un entrefer entre la pointe de cette électrode et cette face à usiner,
    - un capteur de forme de cette pointe, et
    - une unité de commande apte :

• à déterminer l'usure de la pointe à partir des mesures du capteur de forme, et

• à commander l'actionneur pour ajuster la largeur de l'entrefer en fonction de l'usure déterminée.

Ces modes de réalisation de la machine d'usinage par micro-électroérosion présentent en outre les avantages suivants :

- utiliser un mécanisme qui permet de transporter l'électrode de gravure entre un bain de fluide diélectrique et un bain d'électrolyte permet de modifier simplement la configuration de la machine,

- déplacer les bains de fluide diélectrique et d'électrolyte par rapport à l'électrode permet également de modifier simplement la configuration de la machine,

- utiliser des bains de fluide diélectrique et d'électrolyte superposés l'un au-dessus de l'autre dans un même bac permet de simplifier le mécanisme permettant de passer de la configuration d'usinage à la configuration d'affûtage et vice versa,

- utiliser le même actionneur pour régler la largeur de l'entrefer lors de l'usinage et pour déplacer l'électrode par rapport à la surface du bain d'électrolyte décroît le coût de réalisation de cette machine ;

- ajuster la largeur de l'entrefer en fonction de l'usure de la pointe de l'électrode permet d'améliorer la précision d'un usinage tridimensionnel.

L'invention a également pour objet un procédé d'usinage d'une pièce par micro-électroérosion à l'aide d'une machine configurable de micro-électroérosion. Ce procédé comprend l'actionnement d'un mécanisme permettant de modifier la configuration de la machine pour passer en alternance et de façon réversible entre :

- une configuration d'usinage dans laquelle une pointe d'une électrode de gravure est plongée dans un bain de fluide diélectrique baignant une face à usiner de la pièce pour réaliser un usinage de cette pièce par électroérosion, cette pointe étant suffisamment petite pour permettre la gravure de sillons dans la face dont la largeur transversale est inférieure à 10 μm, et

- une configuration d'affûtage dans laquelle la pointe de la même électrode de gravure et une autre électrode sont plongées dans un bain d'électrolyte pour réaliser un affûtage par attaque électrochimique de la pointe de l'électrode de gravure.

Les modes de réalisation de ce procédé peuvent comporter une ou plusieurs des caractéristiques suivantes :

- le procédé comprend :

- la mesure de la forme de la pointe,
- la détermination de l'usure de la pointe à partir de ces mesures, et

- le déclenchement du passage automatique de la configuration d'usinage vers la configuration d'affûtage dès que l'usure déterminée franchit un seuil prédéterminé ;

- avant le passage à la configuration d'usinage, le procédé comprend :

- la mesure de la forme de pointe
- la comparaison de la forme mesurée à un gabarit prédéterminé, et
- l'autorisation du passage à la configuration d'usinage si la forme est comprise dans le gabarit prédéterminé et, dans le cas contraire, l'inhibition du passage à la configuration d'usinage ;

- le procédé comprend :

- la mesure de la forme de la pointe,
- la détermination de l'usure de la pointe à partir des mesures de sa forme, et
- l'ajustement de la largeur d'un entrefer entre la pointe et la face à usiner en fonction de l'usure déterminée.

Les modes de réalisation de ce procédé d'usinage par micro-électroérosion présentent en outre les avantages suivants :

- vérifier l'usure de l'électrode au moins une fois pendant le processus d'usinage et, avantageusement, à plusieurs reprises, permet d'empêcher l'usinage d'une pièce à l'aide d'une électrode défectueuse.

- déclencher l'affûtage de la pointe de l'électrode en fonction de l'usure déterminée de cette pointe permet de réaffûter cette pointe uniquement lorsque cela est nécessaire,

- autoriser le passage à la configuration d'usinage uniquement si la forme de la pointe est comprise dans un gabarit prédéterminé permet d'empêcher l'usinage d'une pièce à l'aide d'une électrode défectueuse.

L'invention sera mieux comprise à la lecture de la description qui va suivre, donnée uniquement à titre d'exemple non limitatif et faite en se référant aux dessins sur lesquels :

- la figure 1 est une illustration schématique et en perspective d'une machine d'usinage par micro-électroérosion,

- la figure 2 est un organigramme d'un procédé d'usinage par micro-électroérosion à l'aide de la machine de la figure 1,

- les figures 3 à 8 sont des illustrations schématiques de différents stades d'affûtage d'une électrode de gravure de la machine de la figure 1,

- la figure 9 est une illustration schématique d'un usinage tridimensionnel réalisé à l'aide de la machine de la figure 1,
- la figure 10 est une illustration schématique et partielle d'un autre mode de réalisation d'une machine d'usinage par micro-électroérosion.

Dans ces figures, les mêmes références sont utilisées pour désigner les mêmes éléments.

Dans la suite de cette description, les caractéristiques et fonctions bien connues de l'homme du métier ne sont pas décrites en détails.

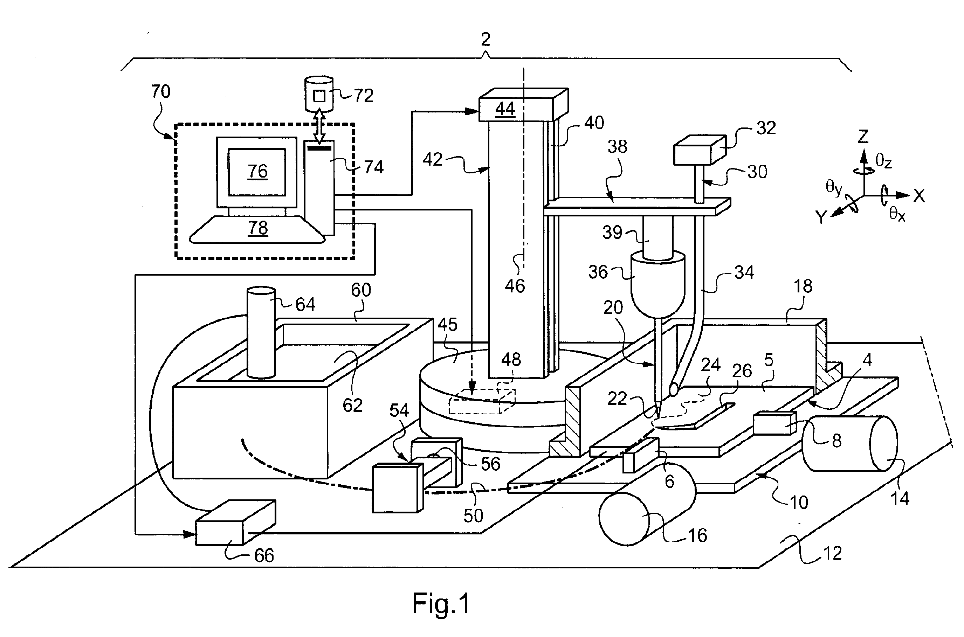

La figure 1 représente une machine 2 d'usinage par micro-électroérosion d'une pièce 4. Cette machine 2 est configurable. Elle peut passer d'une configuration d'usinage à une configuration d'affûtage et vice versa. Dans la configuration d'usinage, la machine permet d'usiner la pièce 4. Dans la configuration d'affûtage, la machine 4 permet d'aiguiser une électrode de gravure. Dans ce mode de réalisation, pour passer de la configuration d'usinage vers la configuration d'affûtage, une électrode de gravure est transportée d'un poste d'usinage vers un poste d'affûtage. Sur la figure 1, la machine est représentée dans sa configuration d'usinage.

Ici, la pièce 4 est un substrat parallélépipédique réalisé dans un matériau semi-conducteur ou conducteur. Par exemple, le matériau semi-conducteur peut être du silicium ou du phosphure d'indium (InP) ou autre. Le matériau conducteur peut être de l'acier, du carbure de silicium, du titane ou autre.

La pièce 4 présente une face supérieure horizontale 5 à usiner.

La pièce 4 est attachée sans aucun degré de liberté sur un porte-substrat 10 mobile. Par exemple, la pièce 4 est coincée entre des butées 6 et 8 qui la maintiennent sur le porte-substrat 10.

Le porte-substrat 10 est déplaçable horizontalement par rapport à un plan horizontal 12 de travail. A cet effet, la machine 2 comprend des moteurs de mouvements de translation, par exemple des actionneurs piézoélectriques 14 et 16 aptes à déplacer le porte-substrat 10, respectivement, dans deux directions X et Y horizontales et perpendiculaires. Ces actionneurs 14 et 16 sont commandables. Ici, les actionneurs piézoélectriques 14 et 16 ont une résolution inférieure ou égale à 3 nm. Ils disposent d'un capteur de position qui permet de contrôler la position absolue du porte-substrat 10 à 6 nm près.

Pour simplifier, l'exposé nous prendrons comme exemple principal des actionneurs piézoélectriques à base d'empilements (« stack » en anglais) de céramiques piézoélectriques avec ou sans amplification mécanique. Ces actionneurs piézoélectriques sont décrits dans la documentation technique du fabricant Physik Instrumente par exemple (http://www.physikinstrumente.com/).

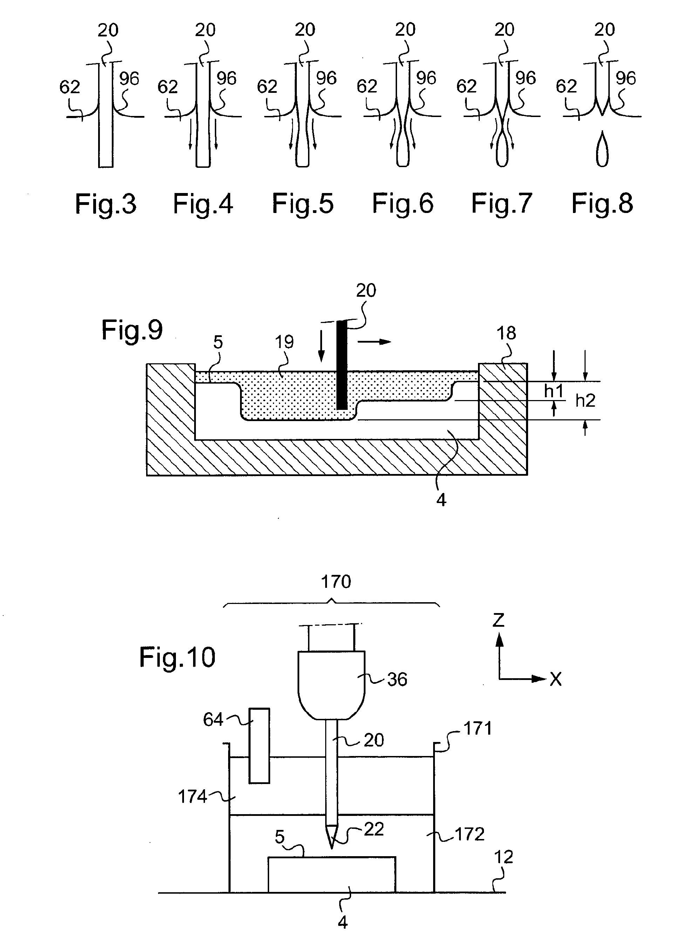

La pièce 4 est plongée dans un bain 19 (Figure 9) de fluide diélectrique contenu dans un bac 18. Les parois verticales du bac 18 entourent la pièce 4 de manière à ce que la face 5 soit baignée dans le bain 19. Sur la figure 1, pour que la pièce 4 soit visible, seules les parois verticales du bac 18 situées en arrière de la pièce 4 ont été représentées.

Le fluide diélectrique contenu dans le bac 18 est un fluide isolant, c'est-à-dire que sa résistivité doit être importante. Par résistivité importante on désigne une résistivité supérieure à 0,1 MΩ.cm et, de préférence, supérieure à 1 MΩ.cm. Par exemple, le fluide diélectrique est ici de l'eau déionisée présentant une résistivité supérieure à 1 MΩ.cm comme décrit dans l'article suivant :

Do Kwan Chung, Bo Hyun Kim and Chong Nam Chu, Micro electrical discharge milling using deionized water as a dielectric fluid, Journal of Micromechanics and Microengineering, vol 17 (2007) 867-874.

De préférence, la résistivité électrique du fluide diélectrique sera aussi importante que possible. En effet, plus la résistivité électrique est importante, plus l'entrefer entre une électrode de gravure et la face 5 est petit et plus l'usinage est précis.

La machine 2 comprend une électrode 20 de gravure. Cette électrode 20 présente du côté de son extrémité libre une pointe 22.

Lorsque la machine 2 est dans sa configuration d'usinage comme représenté sur la figure 1, l'extrémité de la pointe 22 est séparée de la face supérieure de la pièce 4 par un entrefer de largeur L. Cet entrefer doit être suffisamment grand pour isoler électriquement la pointe 22 de la face 5. Cet entrefer doit également être suffisamment petit pour que lorsqu'une différence de potentiel est appliquée entre l'électrode 20 et la pièce 4, un arc électrique puisse se produire dans cet entrefer. L'électrode 20 est ici utilisée pour réaliser un usinage tridimensionnel par électroérosion dans la face 5. À cet effet, l'électrode 20 suit une trajectoire d'usinage représentée sur la face 5 par une ligne en pointillés 24.

Sur la figure 1, on a également représenté un sillon 26 déjà gravé dans la face 5 à l'aide de l'électrode 20. Ce sillon peut comporter des variations de hauteur continue ou discontinue. La figure 9 montre des variations continues de hauteur. La trajectoire peut également comporter des variations discontinues, par exemple un trou vertical, éventuellement débouchant de l'autre coté de la pièce, qui pourrait être ajouter après l'usinage du sillon 26.

La pointe 22 présente un facteur de forme important, c'est-à-dire supérieur à dix. Par facteur de forme, on désigne ici le rapport entre la longueur de la pointe 22 et sa largeur, et ce au voisinage de son extrémité libre. La longueur est mesurée en partant de l'extrémité distale de la pointe 22 et en remontant vers l'extrémité opposée. Cette longueur est mesurée en autorisant une variation de 10 % du diamètre de la pointe. Généralement, ce facteur de forme est compris entre dix et cent. Un facteur de forme important de la pointe permet également de graver dans la pièce 4 des motifs ayant un facteur de forme important. Toute la longueur rentrant dans le critère de variation de 10 % pourra être utilisée pour l'usinage.

Ici, l'électrode 20 est conçue pour être capable de graver dans la pièce 4 des sillons dont la largeur transversale est comprise entre 10 nm et 10 $\mu$m, typiquement entre 100 nm et 1 $\mu$m. La largeur du plus petit sillon que l'on souhaite graver détermine le diamètre de la pointe 22. En effet, ce diamètre doit être inférieur à la largeur transversale du plus petit sillon à graver.

Ici, la partie de l'électrode 20 à l'opposée de la pointe est en général de forme cylindrique. Par exemple, le diamètre de cette partie est compris entre 100 et 500 $\mu$m, typiquement 250 $\mu$m pour que l'ensemble de la pointe ait une tenue mécanique suffisante. Il est bien évident que le diamètre de l'électrode diminue lorsque l'on se déplace de cette partie vers la partie affûtée avec une zone de transition qui ne sera utilisée ni pour l'affûtage ni pour l'usinage. À titre d'exemple, la longueur totale de l'électrode 20 est de 1 cm.

Idéalement, l'extrémité de la pointe 22 ne présente que quelques atomes d'épaisseur. Pour cela, la méthode décrite aux Figures 3 à 8 est utilisée. Pour plus d'information sur ce procédé d'affûtage, il est possible de se référer au document suivant qui appartient à un domaine technique éloigné, c'est-à-dire celui des microscopes à force atomique ou les microscopes tunnel à balayage :

> J. P. Ibe, J. P. P. Bey, S. L. Brandow, R. A. Brizzolara, N. A. Burnham, D. P., DiLella, K. P. Lee, C. R. K. Marrian, and R. J. Colton, "On the electrochemical etching of tips for scanning tunneling microscopy," Journal of Vacuum Science & Technology A: Vacuum, Surfaces, and Films, vol. 8, pp. 3570-3575, 1990.

L'électrode 20 est par exemple en platine-iridium (PtIr) ou en tungstène (W).

A chaque fois qu'un arc électrique se produit entre la pointe 22 et la face 5, de petites particules de matière sont arrachées à la pièce 4. Pendant le processus d'usinage, des particules de matières peuvent rester dans l'entrefer. Or, ces particules sont dans la même matière que la pièce 4, c'est-à-dire dans une matière semi-conductrice ou conductrice. Elles peuvent donc modifier localement la conductivité du fluide diélectrique entre la pointe 22 et la face 5.

Pour réduire ce phénomène, il est nécessaire de renouveler le fluide diélectrique. A cet effet, la machine 2 comprend un projecteur 30 de fluide diélectrique au voisinage de l'entrefer. Ce projecteur permet d'évacuer les particules semi-conductrices ou conductrices présentes dans cet entrefer. Ce projecteur 30 permet donc de restaurer, au moins en partie, la faible conductivité du fluide diélectrique présent dans cet entrefer. Par exemple, et très schématiquement, le projecteur 30 peut être formé d'une pompe commandable 32 et d'un tuyau 34 propre à projeter le fluide diélectrique pompé par la pompe 32 vers l'entrefer.

L'extrémité de l'électrode 20 opposée à la pointe 22 est maintenue verticale et sans aucun degré de liberté dans un mandrin 36. Le mandrin 36 est solidaire d'une plaque 38. La plaque 38 est uniquement déplaçable dans une direction Z verticale et perpendiculaire aux axes X et Y. À cet effet, par exemple, une extrémité de la plaque 38 est montée à coulissement dans une glissière 40 verticale aménagée dans un profilé vertical 42.

Un actionneur commandable 44 solidaire du profilé 42 permet de déplacer de haut en bas la plaque 38. Par exemple, l'actionneur 44 est un actionneur piézoélectrique dont la résolution est inférieure ou égale à 3 nm.

Des actionneurs 39 permettent également de régler l'inclinaison et l'orientation de l'électrode 20 par rotation $\theta_x$, $\theta_y$, $\theta_z$, respectivement, autour des axes X, Y et Z du référentiel XYZ. Par exemple, ces actionneurs sont logés entre la plaque 38 et le mandrin 36

Pour faire passer la machine 2 de sa configuration d'usinage vers sa configuration d'affûtage, celle-ci comprend un mécanisme de transport de l'électrode 20 du poste d'usinage vers le poste d'affûtage sans qu'il soit nécessaire de démonter cette électrode. De plus, ici, ce mécanisme permet également de transporter l'électrode dans un poste de métrologie.

Le poste d'usinage est celui qui a été décrit jusqu'à présent. Les postes d'affûtage et de métrologie sont décrits ci-dessous.

Le mécanisme de modification de la configuration de la machine 2 comprend une embase 45 montée en rotation autour d'un axe vertical 46 solidaire du plan 12 de travail. Le profilé 42 est fixé sans aucun degré de liberté sur l'embase 45. De plus, la rotation de l'embase 45 autour de l'axe 46 est ici commandée par un actionneur 48 commandable.

Ainsi, lorsque l'embase 45 pivote autour de l'axe 46, l'électrode 20 décrit un arc de cercle horizontal 50. L'arc de cercle 50 est schématiquement représenté dans le plan 12.

Ici, lorsque l'électrode 20 se déplace le long de l'arc 50 en allant de la droite vers la gauche, l'électrode 20 rencontre d'abord le poste de métrologie puis ensuite le poste d'affûtage.

Le poste de métrologie a été représenté entre le poste d'usinage et le poste d'affûtage uniquement pour simplifier l'illustration de la figure 1. Avantageusement, se poste de métrologie est situé au dessus du poste d'usinage pour que le passage du poste d'usinage vers le poste de métrologie et vice versa soit réalisé uniquement à l'aide de l'actionneur 44.

Le poste de métrologie comprend un capteur de position, d'orientation et de forme de la pointe 22. Par capteur de forme, on désigne ici un capteur capable de mesurer au moins une grandeur physique représentative d'une caractéristique géométrie de la pointe qui permet de déterminer l'usure de cette pointe. Avantageusement, le capteur de forme pourra aussi mesurer le diamètre de la pointe 22, son facteur de forme et la hauteur de la zone de transition. Le capteur d'orientation permet de déterminer l'inclinaison de l'électrode par rapport aux axes du référentiel XYZ de la pièce à usiner et par rapport à la surface libre de l'électrolyte. Le capteur de position permet de localiser la position de l'extrémité la plus distale de la pointe 22 dans le référentiel XYZ.

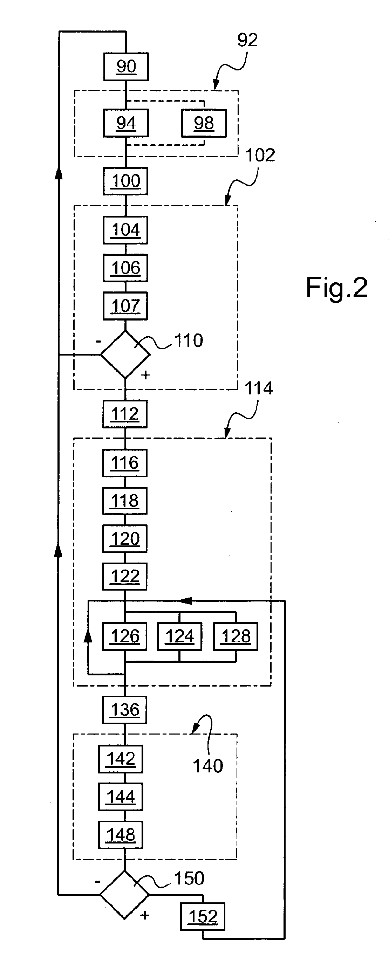

Ici, ces trois capteurs sont réalisés à l'aide d'une seule caméra 54 à très haute résolution. Par « très haute résolution » on désigne ici une caméra dont les pixels ont une taille inférieure à 0,5 $\mu$m et, de préférence, inférieure à 0,3 $\mu$m. Cette caméra 54 présente un objectif 56 positionné à proximité de l'arc 50 de manière à pouvoir filmer la pointe 22 lorsque l'électrode 20 est à l'intérieur du poste de métrologie. La position de cette caméra dans un référentiel XYZ solidaire du plan 12 est fixe et connue. Ainsi, les coordonnées de chaque pixel d'une image filmée par la caméra 54 peuvent être exprimées dans le référentiel XYZ. Le fonctionnement de cette caméra 54 est décrit plus en détail en regard de la figure 2.

Le poste d'affûtage permet de préparer rapidement, c'est-à-dire en moins de 30 minutes, une électrode de diamètre 10 nm à 10 $\mu$m, typiquement 100 nm à 1 $\mu$m, et ce de manière automatique et à un faible coût.

A cet effet, le poste d'affûtage comprend :

- un bac 60 contenant un bain 62 d'électrolyte, et
- une électrode 64 baignant dans le bain 62.

Par exemple, ce bain 62 est un bain d'eau salée (NaCl).

La machine 2 comprend également une source d'alimentation 66 entièrement commandable et commune aux postes d'usinage et d'affûtage. A titre d'exemple, cette source d'alimentation 66 est apte à se comporter :

- dans la configuration d'affûtage, comme un générateur de courant, continu ou non, dans une plage de tension ajustable, pour faire circuler un courant électrique entre les électrodes 20 et 64, lorsque ces électrodes trempent dans le bain 62, et
- dans la configuration d'usinage, comme un générateur de tension, continue ou non, dans une plage de courant ajustable, pour produire une différence de potentiels suffisante pour déclencher l'apparition d'un arc électrique entre la pointe 22 et la face 5 lorsque l'électrode 20 trempe dans le bain 19.

À cet effet, les électrodes 20 et 64 et la pièce 4 sont électriquement raccordées à cette source 66 d'alimentation. Pour simplifier la figure 1, la connexion électrique entre l'électrode 20 et la source d'alimentation 66 a été omise.

La source d'alimentation 66 est également apte à mesurer la différence de potentiel et l'intensité du courant entre l'électrode 20 et la pièce 4 et, en alternance, entre les électrodes 20 et 64.

Enfin, la machine 2 comprend une unité de commande 70 des actionneurs 14, 16, 39, 44 et 48. Cette unité 70 est également apte à commander la source 66 et à acquérir les informations mesurées par la caméra 54. Pour simplifier la figure 1, les connexions entre l'unité 70 et les différents éléments commandés n'ont pas toutes été représentées.

L'unité 70 est réalisée à l'aide d'un calculateur électronique programmable apte à exécuter des instructions enregistrées sur un support d'enregistrement d'informations. Par exemple, à cet effet, l'unité 70 est raccordée à une mémoire 72 contenant les différentes instructions nécessaires pour l'exécution du procédé de la figure 2. De plus, ici, la mémoire 72 contient un fichier dans lequel est stockée la trajectoire prédéterminée de l'électrode 20 pour réaliser l'usinage tridimensionnel souhaité de la pièce 4.

À titre d'exemple, le calculateur électronique est ici un ordinateur équipé d'une unité centrale 74 et d'une interface homme-machine composée d'un écran 76 et d'un clavier 78.

Le fonctionnement de la machine 2 va maintenant être décrit en regard du procédé de la figure 2.

Soit D la longueur initiale de l'électrode et de diamètre intial $\Phi$, par exemple D = 1 cm et $\Phi$ = 250 $\mu$m. Initialement, la machine 2 est amenée dans sa configuration d'affûtage. Par exemple, lors d'une étape 90, l'unité 70 commande les actionneurs 44 et 48 de manière à transporter l'électrode 20 jusqu'au poste d'affûtage. Ensuite, ces actionneurs sont commandés pour faire tremper l'extrémité libre de l'électrode 20 dans le bain 62, de sorte qu'un premier segment de hauteur $\delta$ de l'électrode est en contact avec l'électrolyte. Le segment de hauteur $\delta$ correspond à la partie de l'électrode qui englobera la future pointe, la zone de transition de l'électrode menant au diamètre $\Phi$ et une marge de sécurité. A titre d'exemple, pour un futur diamètre de pointe de 1 $\mu$m, la hauteur $\delta$ est de l'ordre de 50 à 100 $\mu$m. Lorsque l'extrémité libre de l'électrode 20 trempe dans le bain 62, on considère que la machine 2 est dans sa configuration d'affûtage.

Une fois dans la configuration d'affûtage, la machine 2 réalise une étape 92 d'affûtage de l'électrode 20. Nous allons décrire ci-dessous la méthode d'affûtage connue sous le terme anglais de « drop off » telle que rapportée notamment par la,publication :

A. J. Melmed, "The art and science and other aspects of making sharp tips," J. Vac. Sci. Technol. B, vol. 9, pp. 601-608, 1991

Ainsi à titre d'exemple, lors d'une opération 94, l'unité 70 commande la source d'alimentation 66 pour appliquer un courant entre l'électrode 64 et l'électrode 20. Dans ces conditions, un affinement de l'électrode 20 se produit préférentiellement au niveau d'un ménisque 96 (voir Figures 3 à 8) formé par le bain 62 autour de l'électrode 20.

Différents stades successifs d'affinement du segment de hauteur δ lors de l'opération 94 sont représentés sur les figures 3 à 8. L'attaque électrochimique due à la circulation du courant entre les électrodes 20 et 64, affine plus rapidement l'électrode 20 au niveau du ménisque 96 qu'ailleurs. Ainsi, l'attaque électrochimique ronge progressivement l'électrode 20 au niveau de ce ménisque 96 jusqu'à ce que l'extrémité la plus distale du segment de hauteur δ se détache de sa partie principale (Figure 8). Après ce détachement, l'extrémité inférieure de l'électrode 20 est taillée en forme de pointe. Cette pointe est très fine et peut ne faire que quelques atomes de large au niveau de son extrémité distale. La pointe 22 est ainsi réalisée.

Éventuellement, en parallèle de l'opération 94, lors d'une opération 98, l'actionneur 44 est commandé pour progressivement déplacer l'électrode 20 vers le haut. Cette opération 98 permet d'obtenir une pointe 22 plus allongée. Plus de détails sur la façon de commander l'actionneur 44 pour allonger la pointe 22 sont par exemple donnés dans l'article suivant :

> S. H. Choi S. H. Ryu D. K. Choi C. N. Chu, « Fabrication of WC micro-shaft by using electromechanical etching », Int. J. Adv. Manuf. Technol (2007), pages 682-687.

Une fois l'étape 92 d'affûtage terminée, lors d'une étape 100, les actionneurs 44 et 48 sont commandés pour déplacer la pointe 22 jusqu'au poste de métrologie.

Lorsque la pointe 22 est au niveau du poste de métrologie, lors d'une étape 102, la forme, la position et l'inclinaison de cette pointe 22 sont mesurées. Par exemple, lors d'une opération 104, les actionneurs 44 et 48 sont commandés pour placer la pointe 22 exactement en face de l'objectif 56. Ensuite, lors de l'opération 104, la caméra 54 filme la pointe 22, éventuellement en faisant mouvoir la pointe, et transmet les images filmées à l'unité 70. Chaque image constitue une mesure de la forme, de la position et de l'orientation de la pointe 22.

Ensuite, lors d'une opération 106, l'unité 70 corrige optionnellement l'orientation spatiale de l'électrode en commandant les actionneurs 39.

Lors d'une opération 107, elle détermine la relation spatiale qui relie la position de l'extrémité la plus distale de la pointe 22 à la position du mandrin 36. Par exemple, dans le cas où l'électrode 20 est parfaitement verticale, cette relation spatiale se résume à une longueur $l_0$ entre un point de référence sur le mandrin 26 et l'extrémité la plus distale de la pointe 22. Lors de l'opération 107, cette longueur est très précisément mesurée. Lors de l'opération 107 les images reçues sont également traitées pour déterminer le contour de la pointe 22. La position du point de référence sur le mandrin dans le référentiel XYZ est également relevée. La position de ce point de référence est par exemple obtenue à partir de l'état des actionneurs 44 et 48.

Ensuite, lors d'une opération 110, l'unité 70 compare le contour déterminé de la pointe 22 avec un ou plusieurs gabarits prédéterminés. Si le contour déterminé est en dehors des gabarits prédéterminés, alors le procédé retourne à l'étape 90. En effet, cela signifie qu'un défaut d'affûtage de l'électrode 20 s'est produit lors de l'étape 92 de sorte que celle-ci est inapte à usiner correctement la pièce 4. Dans ce cas, l'électrode est par exemple plongée d'un segment supplémentaire de hauteur δ dans l'électrolyte. Ainsi, D/δ opérations de re-affûtage peuvent être effectuées sans que l'opérateur de la machine ait à manipuler l'électrode.

Si le contour de l'électrode correspond au gabarit le procédé se poursuit par une étape 112 de commande des actionneurs 44 et 48 pour faire passer la machine 2 dans sa configuration d'usinage. Dans la configuration d'usinage, la pointe 22 trempe dans le bain 19 de fluide diélectrique du poste d'usinage.

Une fois dans cette configuration d'usinage, une étape 114 d'usinage débute.

Par exemple, lors d'une opération 116, les actionneurs 14, 16, 44 et 48, sont commandés pour positionner la pointe 22 au-dessus du point de départ de la trajectoire d'usinage de la pièce 4.

Ensuite, lors d'une opération 118, une différence de potentiel est appliquée entre l'électrode 20 et la pièce 4. De préférence, l'électrode 20 est mise à la masse et un potentiel positif est appliqué sur la pièce 4. Cette différence de potentiel peut être réalisée directement avec un générateur piloté par des transistors (avec une résistance de sortie finie, avantageusement ajuster, de façon à limiter et à contrôler l'intensité). Elle peut aussi être réalisée indirectement par l'intermédiaire d'un condensateur dans un dispositif connu sous de le nom de générateur à relaxation. Des dispositifs mixtes sont également possibles. Typiquement, la différence de potentiel de travail est ajustée expérimentalement entre 0,1 à 200 V, notamment en fonction de la nature de l'électrode, du diamètre de la pointe, de sa forme exacte (rayon de courbure), de la valeur de l'entrefer, de la nature du diélectrique, de sa conductivité si celle-ci varie pendant l'usinage et de la nature de la pièce à usiner (nature physique, conductivité thermique, capacité calorifique, conductivité électrique, etc.). A titre d'exemple une différence de potentiel de 10 V permet d'usiner du silicium avec une pointe de tungstène de 1 μm de diamètre (diélectrique : eau déinoisée). Pour usiner de l'acier inoxydable avec la même pointe, il est avantageux d'appliquer une tension de 30 à 100 V.

Une fois que l'électrode 20 a été polarisée par rapport à la pièce 4, lors d'une opération 120, l'actionneur 44 est commandé pour rapprocher progressivement la pointe 22 de la face 5. Au fur et à mesure que la pointe 22 se rapproche de la face 5, des arcs électriques se produisent. Les caractéristiques électriques de ces arcs électriques sont surveillées pour détecter le premier arc électrique efficace pour usiner la face 5 de la pièce 4.

Un arc électrique est considéré comme efficace lorsqu'il permet d'éroder la pièce au voisinage de l'entrefer. Il existe différents moyens pour déterminer rapidement si un arc électrique est efficace (avantageusement en ligne pour ne pas interrompre le procédé et pouvoir stabiliser l'usinage). Par exemple, en mesurant le courant d'entrefer dans le cas d'une alimentation électrique pilotée par des transistors ou encore en suivant l'évolution de la différence de potentiel lors de la descente de l'électrode dans le cas d'une alimentation basée sur la charge d'un condensateur. Dans ce dernier cas, une variation brusque de la différence de potentiel correspond souvent à un transfert d'énergie violent conduisant à une érosion. D'autres grandeurs peuvent être utilisées pour qualifier les arcs électriques (fréquences radioélectriques générées pendant l'arc, énergie lumineuses, etc.).

Pour être explicite, les situations autres que des décharges non érodantes, peuvent correspondre à un contact mécanique entraînant un court circuit (qu'il faut impérativement détecter pour éviter de détériorer l'électrode pointe), à un circuit ouvert correspondant à une électrode trop lointaine par rapport à la pièce, ou encore à une fuite électrique dans l'entrefer empêchant l'usinage.

Quoiqu'il en soit, lorsque le premier arc électrique efficace est détecté, la hauteur $z_1$ de l'extrémité la plus distale de la pointe 22 est enregistrée par l'ordinateur lors d'une opération 122, par exemple en notant la position de l'électrode à l'aide d'un capteur de position intégré à l'actionneur 44. La hauteur $z_1$ sert ensuite d'origine pour les déplacements verticaux de l'électrode 20.

Ensuite, lors d'une opération 124, l'usinage proprement dit de la pièce 4 débute. Il est alors nécessaire :

- de continuer à enfoncer verticalement l'électrode, notamment pour compenser l'augmentation de l'entrefer due à l'érosion de la pièce et éventuellement à l'érosion de l'électrode
- de déplacer latéralement et/ou verticalement l'électrode pour usiner la pièce
- et ce tout en appliquant une différence de potentiel ad hoc.

Par exemple, tout en appliquant un différence de potentiel, la pièce 4 est déplacée dans les directions X ou Y, lors d'une opération 124, pour que la pointe 22 suive la trajectoire d'usinage prédéterminée. Simultanément, lors d'une opération 126, l'électrode 20 est déplacée dans la direction Z pour usiner à la profondeur souhaitée. La profondeur d'usinage est ici déterminée par rapport à la position $z_1$ relevée lors de l'opération 122.

Pour obtenir un usinage correct il faut adapter le rythme de création des décharges, le rythme de renouvellement du diélectrique, les vitesses de déplacement et d'enfoncement de l'électrode et donc notamment la variation de l'entrefer. Pour ce faire l'on joue sur le cycle de commande de la différence de potentiel, notamment sur la durée pendant laquelle la différence de potentiel est appliquée et la durée pendant laquelle le système est au repos. Cette dernière durée est souvent mise à profit pour restaurer les conditions diélectriques lors d'une opération 128. Celle-ci consiste à restaurer les propriétés diélectriques originelles du fluide diélectrique présent dans l'entrefer. En effet, ces propriétés diélectriques se dégradent au fur et à mesure de l'usinage étant donné qu'après chaque arc électrique, des particules conductrices ou semi-conductrices sont libérées dans l'entrefer et modifient donc la conductivité électrique entre l'électrode 20 et la pièce 4. Avantageusement, pour restaurer les conditions diélectriques originelles, l'électrode 20 est vibrée de haut en bas avec une amplitude de quelques dizaines à quelques centaines de nanomètres. En parallèle, avantageusement, la pièce 4 est également vibrée. Ces vibrations de la pièce 4 sont obtenues en la déplaçant dans un plan horizontal. Enfin, et également en parallèle, un jet de fluide diélectrique est projeté dans l'entrefer par l'intermédiaire du tuyau 34 pour balayer les particules conductrices et semi-conductrices éventuellement présentes dans cet entrefer.

Régulièrement, on procède à une étape 136 de commande des actionneurs 44 et 48 pour ramener l'électrode 20 dans le poste de métrologie. Ensuite, lors d'une étape 140, l'usure de la pointe 22 est déterminée. Par exemple, lors d'une opération 142, la forme de la pointe 22 est à nouveau mesurée à l'aide de la caméra 54. Les images obtenues sont transmises à l'unité 70.

Lors d'une opération 144, l'unité 70 détermine alors la nouvelle relation spatiale qui relie la position de l'extrémité la plus distale de la pointe 22 et la position du mandrin 36. Par exemple, l'opération 144 est identique à l'opération 104. La longueur mesurée à l'issue de l'opération 144 est notée $l'_0$.

Ensuite, lors d'une opération 148, l'usure de la pointe est donnée par l'écart $\Delta$ suivante :

$$\Delta = l_0 - l'_0$$

Puis, lors d'une étape 150, l'unité 70 vérifie si l'usure déterminée nécessite un réaffûtage de l'électrode 20 ou non. Par exemple, lors de l'étape 150, l'écart $\Delta$ représentatif de l'usure de la pointe 22 est comparé à un seuil $S_1$ prédéterminé. Si ce seuil $S_1$ est franchi alors l'unité 70 déclenche automatiquement la modification de la configuration de la machine 2 et le passage à la configuration d'affûtage. Ceci correspond à un retour à l'étape 90.

Dans le cas contraire, le procédé retourne à l'étape 114 pour usiner une nouvelle pièce ou une nouvelle portion de la face 5 de la pièce 4. Toutefois, avant de retourner à l'étape 114, lors d'une étape 152, l'origine des hauteurs $z_1$ est modifiée en fonction de l'écart $\Delta$. Par exemple, une nouvelle origine des hauteurs $z'_1$ définie par la relation suivante est prise en compte pour les déplacements verticaux de l'électrode 20 :

$$z'_1 = z_1 - \Delta$$

Ainsi, la largeur L de l'entrefer est ajustée en fonction de l'écart $\Delta$ lors de l'usinage suivant de la pièce 4. Ceci permet de procéder directement à l'opération 124 sans passer par les opérations 116 à 122.

On notera qu'ici lorsque le procédé retourne à l'étape 90, la pointe 22 est trempée dans le bain 62 sur une nouvelle hauteur $\delta$ juste au dessus de l'ancienne. Ainsi, lors du réaffûtage, l'attaque électrochimique finit par séparer l'ancienne pointe 22 de la partie principale de l'électrode 20 laissant apparaître une toute nouvelle pointe qui sera utilisée pour le prochain usinage.

L'étape 114 d'usinage s'arrête après que l'ensemble de la trajectoire ait été parcouru.

La figure 9 représente un exemple d'usinage tridimensionnel réalisé à l'aide de la machine 2. Dans cet exemple, la section verticale de la forme à usiner présente deux paliers respectivement à des profondeurs $h_1$ et $h_2$. Les profondeurs $h_1$ et $h_2$ sont mesurées dans la direction Z par rapport à la face 5. Pour usiner le palier à la profondeur $h_1$, l'unité 70 commande l'actionneur 44 de manière à arrêter l'usinage lorsque la pointe 22 est située à la hauteur $z_1 - h_1$.

De façon similaire, le palier à la profondeur $h_2$ est obtenu en arrêtant la gravure de la face 5 lorsque l'électrode 20 est à la hauteur $z_1 - h_2$. La hauteur $z'_1$ est utilisée à la place de $z_1$ lors des usinages suivants et tant que l'usure de la pointe ne dépasse pas le seuil $S_1$.

La figure 10 représente une machine 170 d'usinage par micro-électroérosion. Pour simplifier la figure 10, seule une portion des postes d'usinage et d'affûtage a été représentée.

La machine 170 est identique à la machine 2 sauf que pour passer de la configuration d'usinage à la configuration d'affûtage et vice versa, seul un déplacement vertical dans la direction Z est nécessaire. A cet effet, le bac 18 est remplacé par un bac 171 contenant à la fois un bain 172 de fluide diélectrique et un bain 174 d'électrolyte. La densité volumique du bain 172 est différente de la densité volumique du bain 174. De plus, les bains utilisés 172 et 174 sont non miscibles. Par exemple, sur la figure 10, la densité du bain 172 est supérieure à la densité du bain 174. Dans ces conditions, le bain 174 est situé au-dessus et directement en contact avec le bain 172. La pièce 4 et en particulier la face 5 de cette pièce 4 baigne dans le bain 172.

Le mode de fonctionnement de la machine 170 est similaire à celui de la machine 2. Plus précisément, lors de l'usinage de la face 5 avec l'électrode 20, la pointe 22 trempe dans le bain 172. Lorsqu'il est nécessaire de réaffûter la pointe 22, le mandrin 36 est déplacé verticalement vers le haut pour amener la pointe 22 à l'intérieur du bain 174. Le réaffûtage par attaque électrochimique de l'électrode 20 peut alors avoir lieu.

Dans la machine 170 il n'est pas nécessaire que le profilé 42 soit monté à rotation sur le plan de travail. L'actionneur 48 peut être omis. De même, le bac 60 est supprimé.

De nombreux autres modes de réalisation sont possibles. Par exemple, le fluide diélectrique peut être un gaz et non pas un liquide. Le fluide diélectrique peut aussi être de l'eau pure ou de l'eau mélangée avec de l'alcool. Le fluide diélectrique peut également être tout autre diélectrique utilisé en électroérosion, notamment un hydrocarbure.

Dans le mode de réalisation de la figure 10, la densité du fluide diélectrique peut être inférieure à celle de l'électrolyte de sorte que le bain d'électrolyte est situé en dessous du bain de fluide diélectrique.

La mesure de la forme, de la position et de l'orientation de la pointe 22 peuvent être réalisées par des équipements indépendants l'un de l'autre. Ces équipements peuvent être d'ailleurs partiellement ou totalement intégrés, soit au poste d'usinage, soit au poste d'affûtage. Les mesures peuvent donc être réalisées sans utiliser de caméra et le poste de métrologie peut être omis. Par exemple, les mesures de la forme et de la position peuvent être réalisées par contact mécanique ou électrique entre la pointe 22 et une face de référence. Avantageusement, la mesure de la position et de la forme de la pointe 22 peut être également obtenue en rapprochant très progressivement la pointe 22 d'une face conductrice de référence jusqu'à ce qu'un effet tunnel se produise. Lorsque l'effet tunnel se produit, bien que la pointe 22 ne touche pas la face conductrice, un courant circule entre ces deux éléments. Les caractéristiques électriques et en particulier l'intensité de ce courant permettent d'estimer la position de la pointe par rapport à la face conductrice sans qu'il y ait eu un contact entre ces deux éléments. De préférence, dans ces derniers modes de réalisation, la source d'alimentation 66 délivre un signal électrique très faible, non érodant et/ou non affûtant, permettant de détecter un contact mécanique par détection électrique (ou une approche par effet tunnel) entre l'électrode et la pièce à usiner et/ou la surface de l'électrolyte.

Une caméra supplémentaire avec une ligne de visée parallèle à l'axe Z peut également être utilisée pour filmer la pointe 22 par-dessous. Dans ces conditions, une translation longitudinale de l'électrode se traduit par un déplacement horizontal de la pointe si l'électrode 20 est inclinée. L'amplitude de ce déplacement horizontal est proportionnelle à l'inclinaison de l'électrode 20.

D'autres méthodes de mesure de la forme de la pointe 22 sans contact peuvent être mises en oeuvre telles que par exemple la méthode décrite dans l'article suivant :

H.S. Lim, S.M. Son, Y.S. Wong, M. Rahman, « Development and Evaluation of and on-machine optical measurement device », International Journal of Machine tools and manufacture 47 (2007), pages 1 556 - 1 562.

D'autres méthodes d'affûtage sont possibles toutes basées sur une gravure électrochimique (utilisation de source d'alimentation non continue, à différents niveaux de signal électrique, avec des rampes, des impulsions avec différents rapports cycliques etc.).

Lors d'un nouveau affûtage de la pointe 22, il est également possible de tremper uniquement l'extrémité la plus distale de la pointe pour que celle-ci soit réaiguisée.

Les machines décrites ici ne se limitent pas à un usinage tridimensionnel. Ces machines peuvent également être spécifiquement adaptées pour la réalisation d'usinage plus simple telle que des trous traversant une plaque. Dans ce cas, la machine peut être simplifiée. En effet, la détermination de l'usure de la pointe n'est plus nécessaire et peut être omise.

De nombreuses autres modes de réalisation du mécanisme permettant de modifier la configuration de la machine d'usinage sont possibles. Par exemple, il est possible de déplacer les bains de fluide diélectrique et d'électrolyte par rapport à une électrode fixe dans le repère XYZ. Par exemple, dans ce mode de réalisation, les bacs 18 et 60 sont montés sur un plateau tournant autour de l'axe 46 et le profilé 42 est fixé sans aucun degré de liberté en rotation au plan de travail 12. Ainsi, dans ce mode de réalisation, ce n'est plus l'électrode 20 qui se déplace mais les différents postes à savoir le poste d'usinage, le poste de métrologie et le poste d'affûtage. Le mouvement relatif de l'électrode par rapport aux postes d'usinage et d'affûtage peut être linéaire et non pas circulaire.

Dans une autre variante, la machine comporte un seul bac propre à recevoir en alternance les bains de fluide diélectrique et d'électrolyte. A cet effet, ce bac est équipé de vannes commandables permettant d'une part de vidanger le fluide actuellement présent dans ce bac et d'autres parts de re-remplir le bac à l'aide d'un autre bain. Ainsi, dans ce mode de réalisation, en configuration d'usinage, le bac contient un bain de fluide diélectrique. En configuration d'affûtage, le même bac contient le bain d'électrolyte.

Encore dans un autre mode de réalisation, le mécanisme permettant le passage de la configuration d'usinage à la configuration d'affûtage et vice versa consiste à projeter vers l'entrefer un gaz diélectrique de façon suffisamment violente pour chasser sous l'effet de la pression de ce gaz le bain d'électrolyte. Lorsque ce jet de gaz est interrompu, le bain d'électrolyte réoccupe à nouveau l'entrefer de sorte qu'un affûtage par attaque électrochimique peut avoir lieu.

A la place des actionneurs piézoélectriques à empilements, d'autres actionneurs piézoélectriques sont envisageables, par exemple ceux basés sur une marche du type « collé-glissé » (« stick slip » en anglais). En effet ces dispositifs, dont le principe d'actionnement est basé le mouvement saccadé observé lors du glissement relatifs de deux objets, sont un compromis entre coût, précision de déplacement et course. Lorsque la résolution d'usinage recherchée n'atteint pas 10 nm, notamment lorsque la résolution est comprise entre 100 nm et 1 $\mu$m, d'autres variantes sont possibles. Par exemple on peut disposer sur le même axe de translation, un actionneur piézoélectrique et un moteur électrique de façon à combiner les déplacements, avec comme avantages d'obtenir des courses importantes (typiquement 10 à 100 mm) avec une bonne résolution, Il est avantageux de prévoir un capteur de déplacement tel qu'un capteur capacitif ou une jauge de contrainte dans le cas d'un axe purement piézoélectrique ou une règle optique dans le cas général.

Le renouvellement du fluide diélectrique entre la pointe 22 et la face 5 peut être obtenu par d'autres méthodes. Par exemple, les méthodes suivantes peuvent être utilisées seules ou en combinaison :

- mise en rotation de l'électrode de gravure, par exemple, à l'aide d'un mandrin tournant,
- mise en vibration de l'électrode de gravure, par exemple, à l'aide d'un actionneur piézoélectrique,
- renouvellement global du fluide dans le bac 18.

A titre d'illustration, ces méthodes sont décrites dans le document suivant :

L. Bianchi and E. Rigal, "Usinage par électro-érosion," in Techniques de l'Ingénieur, vol. B7310. Paris, 1987, pp. 24.

L'utilisation de l'usure déterminée pour ajuster la largeur de l'entrefer entre la pointe 22 et la face 5 peut être mise en oeuvre indépendamment du mécanisme permettant de passer de la configuration d'usinage à la configuration d'affûtage. En particulier, une telle façon d'ajuster la largeur de l'entrefer peut être mise en oeuvre dans des machines d'usinage par électroérosion dépourvue d'un tel mécanisme de modification de la configuration de la machine.

**Revendications**

1. Machine d'usinage d'une pièce par micro-électroérosion, cette machine présentant une configuration d'usinage dans laquelle une pointe (22) d'une électrode (20) de gravure est plongée dans un bain de fluide diélectrique baignant une face à usiner de la pièce pour réaliser un usinage de cette pièce par électroérosion, cette pointe (22) étant suffisamment petite pour permettre la gravure de sillons dans la face dont la largeur transversale est inférieure à 10 $\mu$m,
   **caractérisée en ce que** la machine comporte un mécanisme (44, 45, 46, 48) qui permet de modifier la configuration de la machine pour passer en alternance et de façon réversible de la configuration d'usinage à une configuration d'affûtage dans laquelle la pointe de la même électrode de gravure et une autre électrode (64) sont plongées dans un bain (62) d'électrolyte pour réaliser un affûtage par attaque électrochimique de ladite pointe.

2. Machine selon la revendication 1, dans laquelle la machine comporte un premier bac (18) contenant le bain de fluide diélectrique et un second bac (60) contenant le bain d'électrolyte et dans laquelle, le mécanisme (44, 45, 46, 48) est apte à transporter l'électrode de gravure entre les premier et second bacs pour passer de la configuration d'usinage à la configuration d'affûtage et vice versa.

3. Machine selon la revendication 1, dans laquelle la machine comprend un premier bac contenant le bain de fluide diélectrique et un second bac contenant le bain d'électrolyte, et dans laquelle le mécanisme est apte à déplacer les premier et second bacs par rapport à l'électrode de gravure pour passer de la configuration d'usinage vers la configuration d'affûtage et vice versa.

4. Machine selon la revendication 1, dans laquelle la machine comprend un même bac (171) contenant à la fois les bains (172, 174) de fluide diélectrique et d'électrolyte, ces bains ayant des densités volumiques différentes et étant non miscibles de sorte que ces bains sont superposés l'un au-dessus de l'autre.

5. Machine selon l'une quelconque des revendications précédentes, dans laquelle la machine comprend un actionneur (44) apte, dans la configuration d'usinage, à déplacer l'électrode (20) de gravure perpendiculairement à la face à usiner de la pièce pour ajuster la largeur d'un entrefer entre la pointe de cette électrode et cette face à usiner, et dans laquelle le même actionneur (44) est apte, dans la configuration d'affûtage, à déplacer l'électrode de gravure perpendiculairement à la surface du bain d'électrolyte.

6. Machine selon l'une quelconque des revendications précédentes, dans laquelle la machine comprend :

   - un actionneur commandable (44) apte, dans la configuration d'usinage, à déplacer l'électrode (20) de gravure perpendiculairement à la face à usiner de la pièce pour ajuster la largeur d'un entrefer entre la pointe (22) de cette électrode et cette face à usiner,
   - un capteur (54) de forme de cette pointe, et
   - une unité (70) de commande apte :

      • à déterminer l'usure de la pointe à partir des mesures du capteur de forme, et
      • à commander l'actionneur (44) pour ajuster la largeur de l'entrefer en fonction de l'usure déterminée.

7. Procédé d'usinage d'une pièce par micro-électroérosion à l'aide d'une machine configurable de micro-électroérosion, **caractérisé en ce que** ce procédé comprend l'actionnement (90, 112) d'un mécanisme permettant de modifier la configuration de la machine pour passer en alternance et de façon réversible entre :

   - une configuration d'usinage dans laquelle une pointe d'une électrode de gravure est plongée dans un bain de fluide diélectrique baignant une face à usiner de la pièce pour réaliser un usinage de cette pièce par électroérosion, cette pointe étant suffisamment petite pour permettre la gravure de sillons dans la face dont la largeur transversale est inférieure à 10 μm, et
   - une configuration d'affûtage dans laquelle la pointe de la même électrode de gravure et une autre électrode sont plongées dans un bain d'électrolyte pour réaliser un affûtage par attaque électrochimique de la pointe de l'électrode de gravure.

8. Procédé selon la revendication 7, dans lequel le procédé comprend :

   - la mesure (104, 142) de la forme de la pointe,
   - la détermination (140) de l'usure de la pointe à partir de ces mesures, et
   - le déclenchement (150) du passage automatique de la configuration d'usinage vers la configuration d'affûtage dès que l'usure déterminée franchit un seuil prédéterminé.

9. Procédé selon la revendication 7 ou 8, dans lequel avant le passage à la configuration d'usinage, le procédé comprend :

   - la mesure (104) de la forme de pointe
   - la comparaison (110) de la forme mesurée à un gabarit prédéterminé, et
   - l'autorisation (110) du passage à la configuration d'usinage si la forme est comprise dans le gabarit prédéterminé et, dans le cas contraire, l'inhibition du passage à la configuration d'usinage.

10. Procédé selon l'une quelconque des revendications 7 à 9, dans lequel le procédé comprend :

   - la mesure (104, 142) de la forme de la pointe,
   - la détermination (140) de l'usure de la pointe à partir des mesures de sa forme, et
   - l'ajustement (152) de la largeur d'un entrefer entre la pointe et la face à usiner en fonction de l'usure déterminée.

**Patentansprüche**

1. Bearbeitungsmaschine eines Werkstücks durch Mikro-Elektroerosion, wobei diese Maschine eine Bearbeitungskonfiguration aufweist, bei der eine Spitze (22) einer Ätzelektrode (20) in ein dielektrisches Fluidbad getaucht wird, das eine zu bearbeitende Fläche des Werkstücks benetzt, um eine Bearbeitung dieses Werkstücks durch Elektroerosion auszuführen, wobei diese Spitze (22) klein genug ist, um das Ätzen von Rillen in der Fläche, deren Querbreite kleiner ist als 10 μm, zu erlauben, **dadurch gekennzeichnet, dass** die Maschine einen Mechanismus (44, 45, 46, 48) aufweist, der es erlaubt, die Konfiguration der Maschine zu ändern, um abwechselnd und umkehrbar von der Bearbeitungskonfiguration zu einer Schleifkonfiguration zu wechseln, bei der die Spitze derselben Ätzelektrode und eine andere Elektrode (64) in ein Elektrolytbad (62) getaucht werden, um das Schleifen durch elektrochemisches Ätzen der Spitze auszuführen.

2. Maschine nach Anspruch 1, bei der die Maschine einen ersten Behälter (18) aufweist, der ein dielektrisches Fluidbad enthält, und einen zweiten Behälter (60), der das Elektrolytbad enthält, und bei der der Mechanismus (44, 45, 46, 48) fähig ist, die Ätzelektrode zwischen dem ersten und dem zweiten Behälter zu transportieren, um von der Bearbeitungskonfiguration zu der Schleifkonfiguration und umgekehrt zu wechseln.

3. Maschine nach Anspruch 1, bei der die Maschine einen ersten Behälter aufweist, der das dielektrische Fluidbad enthält, und einen zweiten Behälter, der das Elektrolytbad enthält, und bei der der Mechanismus fähig ist, den ersten und den zweiten Behälter in Bezug zu der Ätzelektrode zu verlagern, um von der Bearbeitungskonfiguration zu der Schleifkonfiguration und umgekehrt zu wechseln.

4. Maschine nach Anspruch 1, bei der die Maschine ein und denselben Behälter (171) aufweist, der sowohl das dielektrische Fluidbad als auch das Elektrolytbad (172, 174) enthält, wobei diese Bäder unterschiedliche Volumendichten haben und nicht mischbar sind, so dass diese Bäder übereinander liegen.

5. Maschine nach einem der vorhergehenden Ansprüche, bei der die Maschine einen Stellantrieb (44) aufweist, der in der Bearbeitungskonfiguration fähig ist, die Ätzelektrode (20) senkrecht zu der zu bearbeitenden Fläche des Werkstücks zu verlagern, um die Breite einer Spalte zwischen der Spitze dieser Elektrode und dieser zu bearbeitenden Fläche einzustellen, und bei der derselbe Stellantrieb (44) in der Schleifkonfiguration fähig ist, die Ätzelektrode senkrecht zu der Oberfläche des Elektrolytbad zu verlagern.

6. Maschine nach einem der vorhergehenden Ansprüche, bei der die Maschine Folgendes aufweist:

   - einen steuerbaren Stellantrieb (44), der in der Bearbeitungskonfiguration fähig ist, die Ätzelektrode (20) senkrecht zu der zu bearbeitenden Fläche des Werkstücks zu verlagern, um die Breite einer Spalte zwischen der Spitze (22) dieser Elektrode und dieser zu bearbeitenden Fläche einzustellen,
   - einen Formsensor (54) dieser Spitze und
   - eine Steuereinheit (70), die fähig ist,

      • die Abnutzung der Spitze ausgehend von Messungen des Formsensors zu bestimmen und
      • den Stellantrieb (44) zu steuern, um die Breite der Spalte in Abhängigkeit von der bestimmten Abnutzung einzustellen.

7. Verfahren zum Bearbeiten eines Werkstücks durch Mikro-Elektroerosion mit Hilfe einer konfigurierbaren Mikro-Elektroerosionsmaschine, **dadurch gekennzeichnet, dass** das Verfahren das Betätigen (90, 112) eines Mechanismus aufweist, der es erlaubt, die Konfiguration der Maschine zu ändern, um abwechselnd und umkehrbar zu wechseln zwischen:

   - einer Bearbeitungskonfiguration, in der eine Spitze einer Ätzelektrode in ein dielektrisches Fluidbad, das eine zu bearbeitende Fläche des Werkstücks benetzt, getaucht wird, um ein Bearbeiten dieses Werkstücks durch Elektroerosion auszuführen, wobei diese Spitze klein genug ist, um das Ätzen von Rillen zu erlauben, deren Querbreite kleiner ist als 10 μm, und
   - einer Schleifkonfiguration, in der die Spitze derselben Ätzelektrode und einer anderen Elektrode in ein Elektrolytbad getaucht werden, um ein Schleifen durch elektrochemisches Ätzen der Spitze der Ätzelektrode auszuführen.

8. Verfahren nach Anspruch 7, bei dem das Verfahren Folgendes aufweist:

   - das Messen (104, 142) der Form der Spitze,
   - das Bestimmen (140) der Abnutzung der Spitze ausgehend von diesen Messungen, und
   - das Auslösen (150) des automatischen Wechsels von der Bearbeitungskonfiguration zu der Schleifkonfiguration, sobald die bestimmte Abnutzung einen vorbestimmten Schwellenwert überschreitet.

9. Verfahren nach Anspruch 7 oder 8, bei dem vor dem Wechseln zu der Bearbeitungskonfiguration das Verfahren Folgendes aufweist:

  - das Messen (104) der Spitzenform,
  - den Vergleich (110) der gemessenen Form mit einer vorbestimmten Schablone, und
  - das Gestatten (110) des Wechsels zu der Bearbeitungskonfiguration, wenn die Form innerhalb der vorbestimmten Schablone liegt und, im gegenteiligen Fall, das Unterbinden des Wechsels zu der Bearbeitungskonfiguration.

**10.** Verfahren nach einem der Ansprüche 7 bis 9, wobei das Verfahren Folgendes aufweist:

  - das Messen (104, 142) der Form der Spitze,
  - das Bestimmen (140) der Abnutzung der Spitze ausgehend von den Messungen ihrer Form, und
  - das Einstellen (152) der Breite einer Spalte zwischen der Spitze und der zu bearbeitenden Fläche in Abhängigkeit von der bestimmten Abnutzung.

**Claims**

**1.** A machine for machining a part by micro-electrical discharge machining, said machine having a machining configuration in which a tip (22) of an etching electrode (20) is plunged into a bath of dielectric fluid bathing one face to be machined of the part in order to carry out a machining of this part by electrical discharge machining, said tip (22) being small enough to enable the etching of grooves in the face of which cross-width is less than 10 μm, **characterised in that** the machine comprises a mechanism (44, 45, 46, 48) that enables the configuration of the machine to be modified to make it pass alternately and reversibly from the machining configuration to a sharpening configuration in which the tip of the same etching electrode and another electrode (64) are plunged into a electrolyte bath (62) in order to carry out a sharpening of said tip by electrochemical machining.

**2.** The machine according to Claim 1, wherein the machine has a first recipient (18) containing the dielectric fluid bath and a second recipient (60) containing the electrolyte bath, and wherein the mechanism (44, 45, 46, 48) is capable of conveying the etching electrode between the first and second recipients to pass from the machining configuration to the sharpening configuration and vice versa.

**3.** The machine according to Claim 1, wherein the machine comprises a first recipient containing the dielectric fluid bath and a second recipient containing the electrolyte fluid bath, and wherein the mechanism is capable of shifting the first and second recipients relative to the etching electrode to pass from the machining configuration to the sharpening configuration and vice versa.

**4.** The machine according to Claim 1, wherein the machine comprises a same recipient (171) containing the baths (172, 174) of dielectric fluid and electrolyte at the same time, these baths having different mass densities and being non-miscible such that these baths are superimposed, one above the other.

**5.** The machine according any one of the preceding claims, wherein the machine comprises an actuator (44) capable, in the machining configuration, of shifting the etching electrode (20) perpendicularly to the face to be machined of the part in order to adjust the width of a gap between the tip of said electrode and said face to be machined, and wherein the same actuator (44) is capable, in the sharpening configuration, of shifting the etching electrode perpendicularly to the surface of the electrolyte bath.

**6.** The machine according to any one of the preceding claims, wherein the machine comprises:

  - a controllable actuator (44) capable, in the machining configuration, of shifting the etching electrode (20) perpendicularly to the face to be machined of the part to adjust the width of a gap between the tip (22) of this electrode and this face to be machined,
  - a sensor (54) for sensing the shape of this tip, and
  - a control unit (70) capable of:

    • determining the wear of the tip from measurements of the shape sensor, and
    • controlling the actuator (44) to adjust the width of the gap as a function of the determined wear.

**7.** A method for machining a part by micro-electrical discharge machining by means of a configurable machine for micro-electrical discharge machining, **characterised in that** this method includes the actuation (90, 112) of a mechanism for modifying the configuration of the machine to pass alternately and reversibly between:

  - a machining configuration in which a tip of an etching electrode is plunged into a bath of dielectric fluid that bathes a face to be machined in order to perform a machining of this part by electrical discharge machining, this tip being small enough to enable the etching of grooves in the face of which the cross-width is less than 10 μm,

and
- a sharpening configuration in which the tip of the same etching electrode and another electrode are plunged into an electrolyte bath to carry out a sharpening of the tip of the etching electrode by electrochemical machining.

8. The method according to Claim 7, wherein the method comprises:

- measuring (104, 142) the shape of the tip,
- determining (140) the wear of the tip from these measurements, and
- activating (150) the automatic passage from the machining configuration to the sharpening configuration as soon as the determined wear crosses a predetermined threshold.

9. The method according to Claim 7 or 8, wherein, before passing to the machining configuration, the method comprises:

- measuring (104) the shape of the tip,
- comparing (110) the measured shape with a predetermined template, and
- permitting (110) the passage to the machining configuration if the shape is included in the predetermined template and, if not, inhibiting the passage to the machining configuration.

10. The method according to any one of Claims 7 to 9, wherein the method comprises:

- measuring (104, 142) the shape of the tip,
- determining (140) the wear of the tip from the measurements of its shape, and
- adjusting (152) the width of a gap between the tip and the face to be machined as a function of the determined wear.

Fig.1

Fig.2

Fig.3    Fig.4    Fig.5    Fig.6    Fig.7    Fig.8

Fig.9

Fig.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2004168288 A

**Littérature non-brevet citée dans la description**

- **DO KWAN CHUNG ; BO HYUN KIM ; CHONG NAM CHU.** Micro electrical discharge milling using deionized water as a dielectric fluid. *Journal of Micromechanics and Microengineering,* 2007, vol. 17, 867-874
- **J. P. IBE ; J. P. P. BEY ; S. L. BRANDOW ; R. A. BRIZZOLARA ; N. A. BURNHAM ; D. P., DILELLA ; K. P. LEE ; C. R. K. MARRIAN ; R. J. COLTON.** On the electrochemical etching of tips for scanning tunneling microscopy. *Journal of Vacuum Science & Technology A: Vacuum, Surfaces, and Films,* 1990, vol. 8, 3570-3575
- **A. J. MELMED.** The art and science and other aspects of making sharp tips. *J. Vac. Sci. Technol. B,* 1991, vol. 9, 601-608
- **S. H. CHOI ; S. H. RYU ; D. K. CHOI ; C. N. CHU.** Fabrication of WC micro-shaft by using electromechanical etching. *Int. J. Adv. Manuf. Technol,* 2007, 682-687
- **H.S. LIM ; S.M. SON ; Y.S. WONG ; M. RAHMAN.** Development and Evaluation of and on-machine optical measurement device. *International Journal of Machine tools and manufacture,* 2007, vol. 47, 1 556-1 562
- **L. BIANCHI ; E. RIGAL.** Usinage par électro-érosion. *Techniques de l'Ingénieur,* 1987, vol. B7310, 24